# EUROPEAN PATENT APPLICATION

(11) **EP 4 650 892 A1**
(43) Date of publication of application: **19.11.2025**
(21) Application number: 25174334.0
(22) Date of filing: 05.05.2025
(51) Int. Cl.: G05B 19/4093

(54) **DIE HOLDER VERIFICATION**

(30) Priority: 15.05.2024 US 202418664610
(71) Applicant: ContiTech Deutschland GmbH, 30175 Hannover (DE)
(72) Inventor: Pannen, Rick, 30175 Hannover (DE); Dr. Wichmann, Arne, 30175 Hannover (DE); Lee, Chad, Fairlawn, 44333 (US); Banga, Cameron, Fairlawn, 44333 (US)
(74) Representative: Preusser, Andrea

(57) **Abstract**

A die verification system may include a die holder of a crimp machine, the die holder configured to receive die identification. The system may include a user interface, a data interface. The system may include a controller having one or more processors configured to: receive the die identification from the die holder, reference a crimp database with the die identification, fitting information and hose information; and verify that the die identification is suitable for a crimp process.

## Description

### FIELD

The field to which the disclosure relates is hose crimping.

### BACKGROUND

The subject matter related generally to crimping machines and crimping die verification.

### BRIEF DESCRIPTION OF THE DRAWINGS

Fig. 1 is a diagram illustrating a crimp machine die verification system 100 in accordance with one or more embodiments.
Fig. 2 is a diagram illustrating a die set 108 in accordance with one or more embodiments.
Fig. 3 is a diagram illustrating a die identification system or device 104 in accordance with one or more embodiments.
Fig. 4 is a diagram illustrating a die identification reader integration system 400 in accordance with one or more embodiments.
Fig. 5 is a diagram illustrating the die holder identification system 500 in accordance with one or more embodiments.
Fig. 6 is a diagram illustrating a die identification system in accordance with one or more embodiments.
Fig. 7 is a diagram illustrating insertion of a hose and fitting into a die set 108 in accordance with one or more embodiments.
Fig. 8 is a diagram illustrating a die identification system and/or controller in accordance with one or more embodiments.
Fig. 9 is a flowchart of an example method for operating a die verification system.
Fig. 10 is a flowchart of an example method for of operating a die verification system having a die holder.
Fig. 11 is a flowchart of an example method for method of operating a die verification system having a die holder.

### DETAILED DESCRIPTION

The following description of the variations is merely illustrative in nature and is in no way intended to limit the scope of the disclosure, its application, or uses. The description is presented herein solely for the purpose of illustrating the various embodiments of the disclosure and should not be construed as a limitation to the scope and applicability of the disclosure. In the summary of the disclosure and this detailed description, each numerical value should be read once as modified by the term "about" (unless already expressly so modified), and then read again as not so modified unless otherwise indicated in context. Also, in the summary of the disclosure and this detailed description, with the understanding that a value range listed or described as being useful, suitable, or the like, is intended that any and every value within the range, including the end points, is to be considered as having been stated. For example, "a range of from 1 to 10" is to be read as indicating each and every possible number along the continuum between about 1 and about 10. Thus, even if specific data points within the range, or even no data points within the range, are explicitly identified or refer to only a few specific data points, it is to be understood that inventors appreciate and understand that any and all data points within the range are to be considered to have been specified, and that inventors had possession of the entire range and all points within the range.

Unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

In addition, use of the "a" or "an" are employed to describe elements and components of the embodiments herein. This is done merely for convenience and to give a general sense of concepts according to the disclosure. This description should be read to include one or at least one, and the singular also includes the plural unless otherwise stated.

The terminology and phraseology used herein is for descriptive purposes and should not be construed as limiting in scope. Language such as "including", "comprising", "having", "containing", or "involving", and variations thereof, is intended to be broad and encompass the subject matter listed thereafter, equivalents, and additional subject matter not recited.

Also, as used herein, any references to "one embodiment" or "an embodiment" means that a particular element, feature, structure, or characteristic described in connection with the embodiment is included in at least one embodiment. The appearances of the phrase "in one embodiment" in various places in the specification are not necessarily referring to the same embodiment.

Previous approaches to verifying crimp machine dies have typically involved manual processes or standalone systems that are not integrated with the crimp machine itself. These conventional methods often require operators to manually input die set identifications and related information into separate databases or systems, leading to potential errors and inefficiencies in the verification process. Additionally, these manual processes can be time-consuming and may not provide real-time feedback to operators during the crimping operation.

Industrial hoses are attached with fittings to facilitate connection and transport of fluid, air and/or other media. The fittings secure connection to various fluid or pneumatic systems and facilitate reliable transfer of media. The fittings can include, barbed, compression, camlock, quick-disconnect, flange, threaded, push to connect, swivel fittings and the like.

Fittings are generally attached to hoses, including industrial hoses, using a crimping machine. The machine utilizes a set of dies to mechanically compress and/or force the fitting to attach the fitting with the hose. The machine typically presses dies that deform the fitting to mechanically attach the fitting to the hose.

Particular fittings have selected or compatible die sets that match the fitting, hose, and crimping machine. If the wrong die set is used, the fitting assembly can fail prematurely and an improper or leaky connection may result.

Typically, a user manually verifies or checks whether the set of dies used is proper. However, errors can occur, for example by failing to check or erroneously verifying an incorrect set of dies.

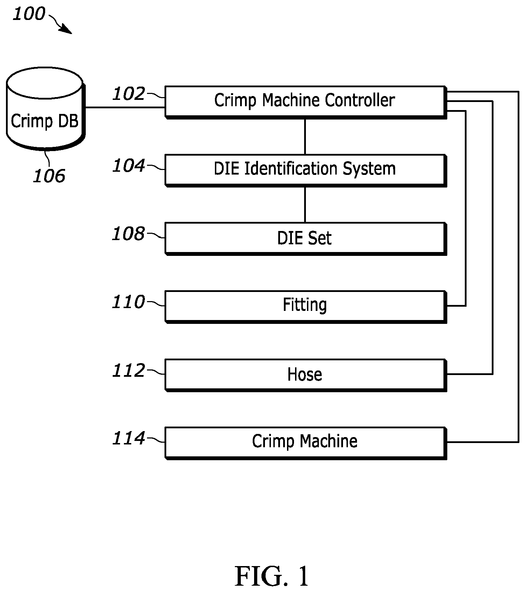

Fig. 1 is a diagram illustrating a crimp machine die verification system 100 in accordance with one or more embodiments. The system is provided for illustrative purposes and suitable variations are contemplated.

The system 100 includes a crimp machine controller 102, a die identification system 104 and a crimp database 106.

The crimp machine controller 102 is a control system that manages crimping processes for a crimp machine 114 that assembles a fitting 110 and a hose 112 using a die set 108. The controller 102 provides accuracy and consistency. The controller 102 regulates a force applied during a crimping process to provide a consistent and reliable assembly. The controller 102 controls crimping parameters such as crimping force, duration and the like to perform the crimping process. Additionally, the controller 102 monitors the crimping process to detect errors and can provide feedback to further adjust the crimping process.

The controller 102 is typically integrated with the crimp machine 114 and includes a user interface for inputting information and displaying information.

The die identification system 104 provides die or die set identification and associated information for the die set 108. The die identification and/or information can include manufacturer, manufacturer date, force tolerances, temperature tolerances, die color, die calibration and the like.

The crimp database 106 includes correlation information for hoses, fittings and die sets. The controller 102 accesses the database to determine crimping parameters for hose assemblies, including the fitting 110 and the hose 112. The crimp database 106 can be integrated with the crimp machine 114, remote from the controller 102, in a cloud and the like.

Additionally, the controller 102 utilizes the die identification to verify or determine if the die set 108 is suitable for the crimping process of the fitting 110 and the hose 112.

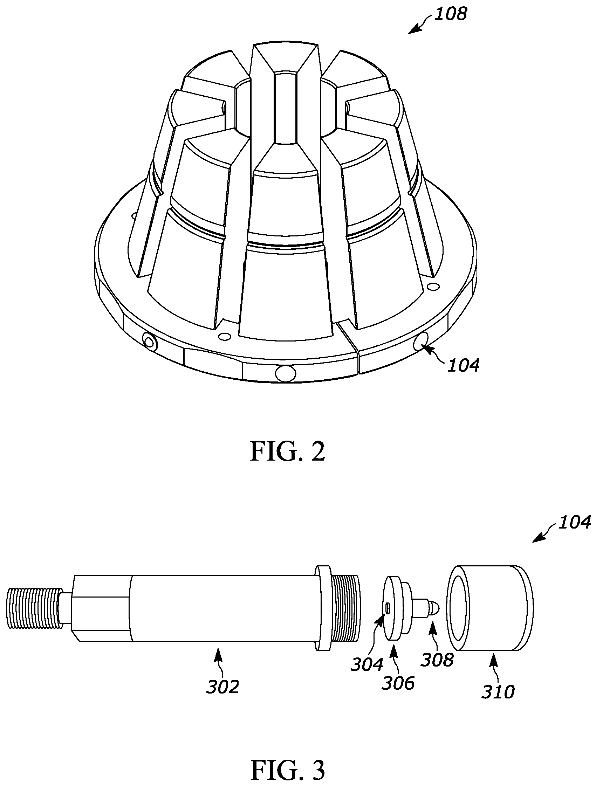

Fig. 2 is a diagram illustrating a die set 108 in accordance with one or more embodiments. The system is provided for illustrative purposes and suitable variations are contemplated.

The die set 108 includes a plurality of individual dies that are compressed inward during a crimp process.

The die set 108 is typically comprised of a metal material that resists deformation under force, such as steel.

One or more of the die set 108 includes the die identification system 104. System 104 is associated with the die set 108 and includes the die identification and related information, as described above.

Fig. 3 is a diagram illustrating a die identification system or device 104 in accordance with one or more embodiments. The system is provided for illustrative purposes and suitable variations are contemplated.

The system 104, in this example includes a body 302, circuitry 304, a printed circuit board (PCB) 306, a contact or activation 308 and a cap 310. The circuitry 304 can include a semiconductor die or the like. The contact or activation 308 can be in the form of a switch or other activatable component.

The body 302 encloses the die 304, the PCB 306 and the contact 308 and is comprised of a suitable material that resists deformation, such as steel.

The die 304 includes an integrated circuit and the like for providing the die identification and information. The die 304 is located on the PCB 306, which can also have other components such as power regulation devices, interfaces, memory, storage, transceivers and the like.

The contact or activation device 308 typically triggers the die 304 to provide the die identification and information. The device 308 can also receive power and/or be used for communication of the die identification and information.

In one example, the contact 308 is a spring like conductive mechanism that engages with a metal contact of a die holder and is activated upon insertion of the die set into the die holder.

In another example, the contact 308 has a transceiver and uses near field communication (NFC) to activate and/or initiate transfer of the die information upon the system being within range of a die holder, crimp machine, or other devices, such as a mobile phone, tablet, and the like. NFC operates at frequencies, such as 13.56 MHz, and permits contactless communication between devices.

The die 304 stores die identification for a set of dies. This dentification can include a unique identification for the die, model number, die color, die weight, die size, die material, and the like.

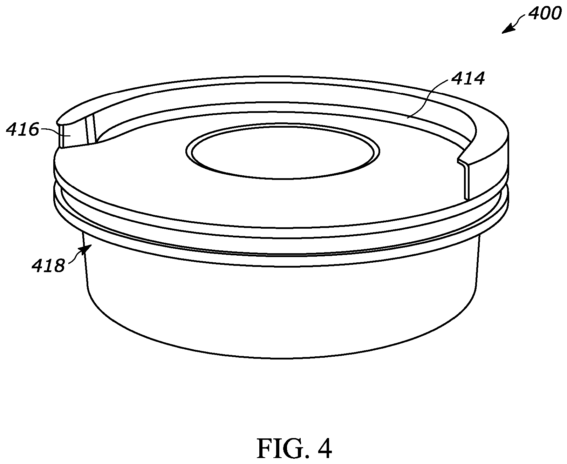

Fig. 4 is a diagram illustrating a die identification reader integration system 400 in accordance with one or more embodiments. The system is provided for illustrative purposes and suitable variations are contemplated.

The system 400 is typically part of the crimp machine 114 and mechanically holds the die set 108 during the crimp process.

The system 400 includes a die holder 418, a contact frame 416 and a contact rail 414.

The die holder 418 mechanically holds the die set 108.

The contact rail 414 provides an electrical connection to the die system 104, such as a negative or ground connection.

The contact frame 416 also provides an electrical connection to the system 104. Further, the contact frame 416 provides a positive power and data connection, referred to as a one wire connection, between the die identification system 104 and the crimp machine controller 102.

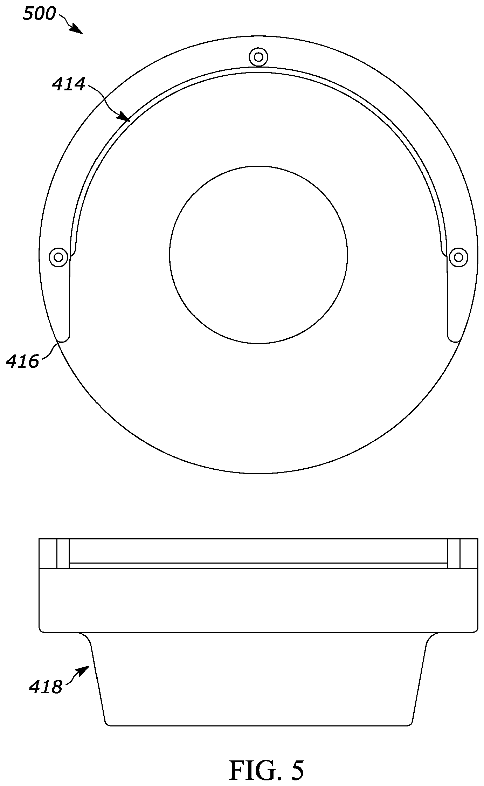

Fig. 5 is a diagram illustrating the die holder identification system 500 in accordance with one or more embodiments. The system is provided for illustrative purposes and suitable variations are contemplated.

This is another view of the system 400.

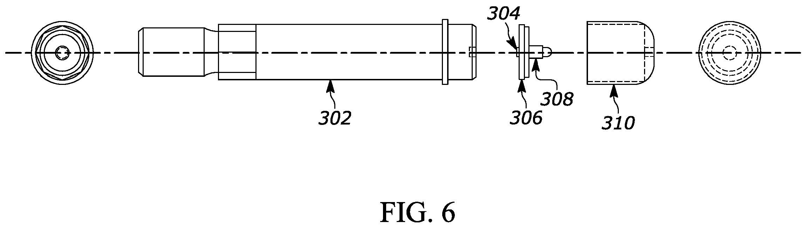

Fig. 6 is a diagram illustrating a die identification system in accordance with one or more embodiments. The system is provided for illustrative purposes and suitable variations are contemplated.

The system shown can be used as the system 104.

The system includes a body 302, an identification chip or die 304, a printed circuit board (PCB) 306, a contact or activation 308 and a cap 310.

The body 302 encloses the die 304, the PCB 306 and the contact 308 and is comprised of a suitable material that resists deformation, such as steel.

The die 304 includes an integrated circuit and the like for providing the die identification and information. The die 304 is located on the PCB 306, which can also have other components such as power regulation devices, interfaces, memory, storage, transceivers and the like.

The contact or activation device 308 typically triggers the die 304 to provide the die identification and information. The device 308 can also receive power and/or be used for communication of the die identification and information.

The body 302 can include threads and the like to secure the system into one or more die of the die set.

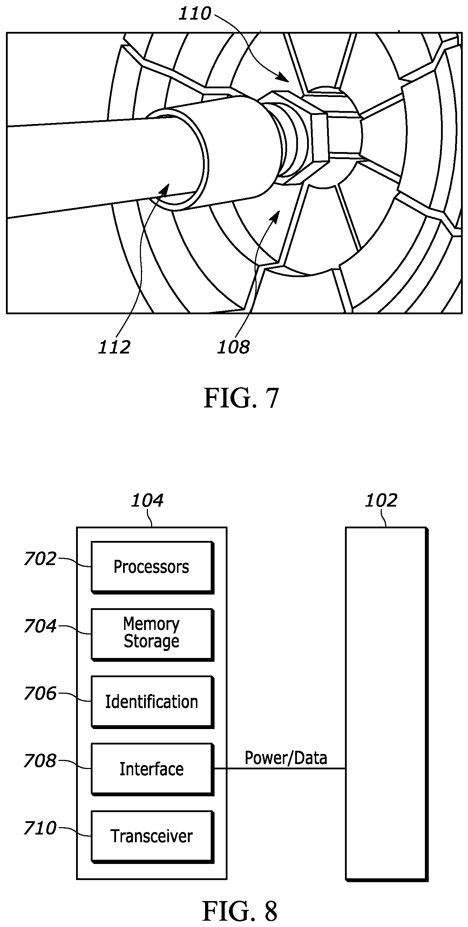

Fig. 7 is a diagram illustrating insertion of a hose and fitting into a die set 108 in accordance with one or more embodiments. The system is provided for illustrative purposes and suitable variations are contemplated.

The fitting 110 has an inner part inserted into the hose 112 and an outer part over an outside surface of the hose 112.

During the crimp process, the die set 108 moves inward and deforms the outer part to secure the fitting 110 with the hose 112.

Fig. 8 is a diagram illustrating a die identification system and/or controller in accordance with one or more embodiments. The system is provided for illustrative purposes and suitable variations are contemplated.

The system of Fig. 8 can be used for the system 104 and/or the controller 102.

The system includes one or more processors 702, a memory or storage 704, an identification register 706, an interface 708 and a transceiver 710.

The interface permits communication with the controller 102, the database 106 and the like.

The identification register 706 stores and maintains the die identification. The die identification can include a unique identification number (UID) specific to the die set 108.

The memory 704 and/or the register 706 can maintain die related information, as described above.

The transceiver 710 facilitates communication of the die identification and information by formatting and arranging data for transmission by one-wire, wired communication, wireless communication and the like.

The transceiver 710 can also utilize near field communications (NFC), such as Bluetooth and the like.

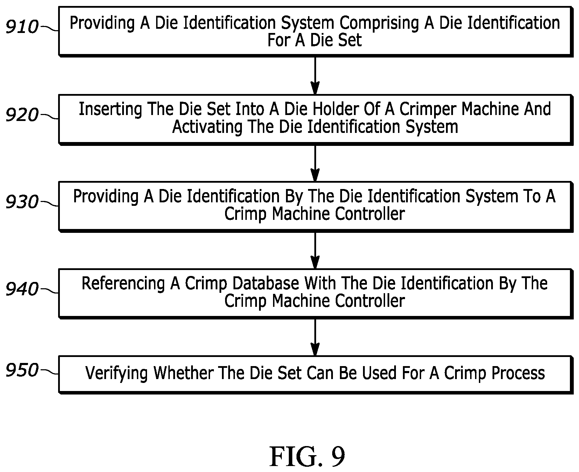

Fig. 9 is a flowchart of an example method for operating a die verification system. Suitable variations of the method are contemplated.

The method can be performed using the above systems and descriptions.

At step 910, a die identification system comprising a die identification for a die set is provided. The system can include a body 302, circuitry 304, PCB 306, contact 308 and cap 310.

At step 920, inserting the die set into a die holder of a crimper machine and activating the die identification system is performed.

At step 930, providing a die identification by the die identification system to a crimp machine controller is performed.

At step 940, referencing a crimp database with the die identification by the crimp machine controller is performed.

At step 950, verifying whether the die set can be used for a crimp process is performed.

Subsequently, the die set is used to crimp and assemble a fitting and a hose.

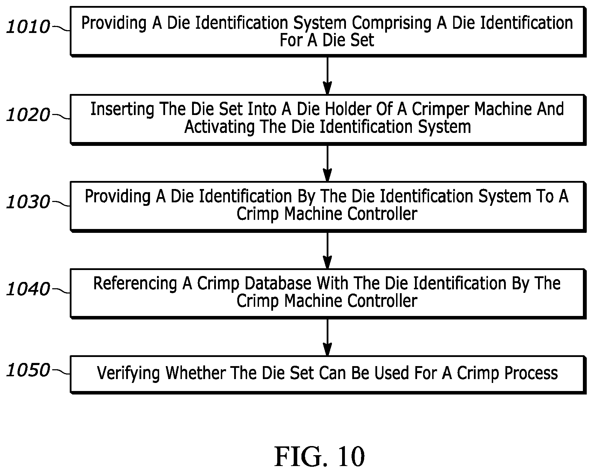

Fig. 10 is a flowchart of an example method for of operating a die verification system having a die holder, the method comprising:
At step 1010, providing a die identification system comprising a die identification for a die set.

At step 1020, inserting the die set into a die holder of a crimper machine and activating the die identification system.

At step 1030, providing a die identification by the die identification system to a crimp machine controller.

At step 1040, referencing a crimp database with the die identification by the crimp machine controller.

At step 1050, verifying whether the die set can be used for a crimp process.

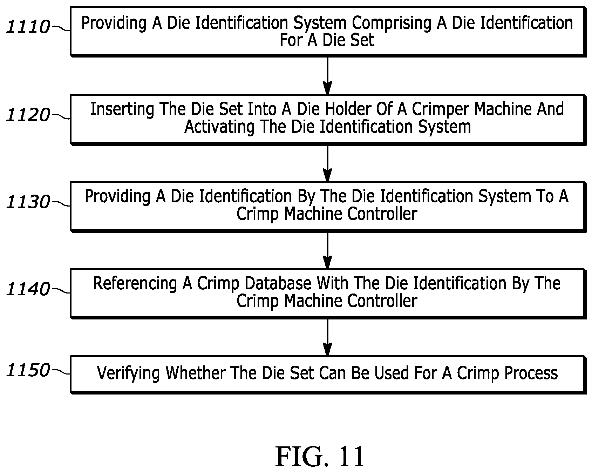

Fig. 11 is a flowchart of an example method for method of operating a die verification system having a die holder, the method comprising:
At step 1110, providing a die identification system comprising a die identification for a die set.

At step 1120, inserting the die set into a die holder 500 of a crimper machine and activating the die identification system.

At step 1130, providing a die identification by the die identification system to a crimp machine controller.

At step 1140, referencing a crimp database with the die identification by the crimp machine controller.

At step 1150, verifying whether the die set 104 can be used for a crimp process.

It is appreciated that suitable variations of the method are contemplated.

The foregoing description of the embodiments has been provided for purposes of illustration and description. Example embodiments are provided so that this disclosure will be sufficiently thorough and will convey the scope to those who are skilled in the art. Numerous specific details are set forth such as examples of specific components, devices, and methods, to provide a thorough understanding of embodiments of the disclosure but are not intended to be exhaustive or to limit the disclosure. It will be appreciated that it is within the scope of the disclosure that individual elements or features of a particular embodiment are generally not limited to that particular embodiment, but, where applicable, are interchangeable and can be used in a selected embodiment, even if not specifically shown or described. The same may also be varied in many ways. Such variations are not to be regarded as a departure from the disclosure, and all such modifications are intended to be included within the scope of the disclosure.

Also, in some example embodiments, well-known processes, well-known device structures, and well-known technologies are not described in detail. Further, it will be readily apparent to those of skill in the art that in the design, manufacture, and operation of apparatus to achieve that described in the disclosure, variations in apparatus design, construction, condition, erosion of components, gaps between components may present, for example.

Examples can include subject matter such as a method, means for performing acts or blocks of the method, at least one machine-readable medium including instructions that, when performed by a machine cause the machine to perform acts of the method or of an apparatus or system for concurrent communication using multiple communication technologies according to embodiments and examples described herein.

As used herein, the term "circuitry" may refer to, be part of, or include an Application Specific Integrated Circuit (ASIC), an electronic circuit, a processor (shared, dedicated, or group), and/or memory (shared, dedicated, or group) that execute one or more software or firmware programs, a combinational logic circuit, and/or other suitable hardware components that provide the described functionality. In some embodiments, the circuitry may be implemented in, or functions associated with the circuitry may be implemented by, one or more software or firmware modules. In some embodiments, circuitry may include logic, at least partially operable in hardware.

As it is employed in the subject specification, the term "processor" can refer to substantially any computing processing unit or device including, but not limited to including, single-core processors; single-processors with software multithread execution capability; multi-core processors; multi-core processors with software multithread execution capability; multi-core processors with hardware multithread technology; parallel platforms; and parallel platforms with distributed shared memory. Additionally, a processor can refer to an integrated circuit, an Application Specific Integrated Circuit, a Digital Signal Processor, a Field Programmable Gate Array, a Programmable Logic Controller, a Complex Programmable Logic Device, a discrete gate or transistor logic, discrete hardware components, or any combination thereof designed to perform the functions and/or processes described herein. Processors can exploit nano-scale architectures such as, but not limited to, molecular and quantum-dot based transistors, switches and gates, in order to optimize space usage or enhance performance of mobile devices. A processor may also be implemented as a combination of computing processing units.

Although the terms first, second, third, etc. may be used herein to describe various elements, components, regions, layers and/or sections, these elements, components, regions, layers and/or sections should not be limited by these terms. These terms may be only used to distinguish one element, component, region, layer or section from another region, layer or section. Terms such as "first", "second", and other numerical terms when used herein do not imply a sequence or order unless clearly indicated by the context. Thus, a first element, component, region, layer or section discussed below could be termed a second element, component, region, layer or section without departing from the teachings of the example embodiments.

Spatially relative terms, such as "inner", "adjacent", "outer", "beneath", "below", "lower", "above", "upper", and the like, may be used herein for ease of description to describe one element or feature's relationship to another element(s) or feature(s) as illustrated in the figures. Spatially relative terms may be intended to encompass different orientations of the device in use or operation in addition to the orientation depicted in the figures. For example, if the device in the figures is turned over, elements described as "below" or "beneath" other elements or features would then be oriented "above" the other elements or features. Thus, the example term "below" can encompass both an orientation of above and below. The device may be otherwise oriented (rotated 90 degrees or at other orientations) and the spatially relative descriptors used herein interpreted accordingly.

In some aspects, the techniques described herein relate to a crimp machine die verification system including: a body 302; circuitry (306) positioned within the body; a printed circuit board (PCB) 306 that holds the circuitry; wherein the circuitry includes one or more processors configured to: store an identification (704) for a die set; store related information; and transfer the die identification and the related information based on activation.

In some aspects, the techniques described herein relate to a system, further including a contact 308 coupled to the PCB 306, the contact configured to generate the activation of the circuitry;

In some aspects, the techniques described herein relate to a system, the contact is a spring loaded metal contact that engages a metal contact of a die holder.

In some aspects, the techniques described herein relate to a system, the contact activates when proximate a die holder and uses near field communication to provide the die identification.

In some aspects, the techniques described herein relate to a system, wherein the one or more processors are configured to store crimp parameters as the related information to a memory.

In some aspects, the techniques described herein relate to a system, wherein the one or more processors are configured to store crimp parameters as the related information to a database.

In some aspects, the techniques described herein relate to a system, further including a protective cap 310 that encloses the circuitry, PCB and the contact.

In some aspects, the techniques described herein relate to a system, wherein the cap mitigates forces from the die set onto the circuitry.

In some aspects, the techniques described herein relate to a system, the circuitry further includes a transceiver to communicate the die information.

In some aspects, the techniques described herein relate to a system, the circuitry further communicates an interface for power and/or data.

In some aspects, the techniques described herein relate to a system, the circuitry includes a memory in the form of a register to store and program the die identification.

In some aspects, the techniques described herein relate to a system, wherein the body is positioned within a die of the die set and the body is removable.

In some aspects, the techniques described herein relate to a system, wherein the body is screwed into a hole within a die of the die set.

In some aspects, the techniques described herein relate to a system for die verification, the system including: a crimp machine controller to operate a crimp machine; a die set for a fitting and hose assembly; and a die identification system that verifies the die set for the fitting and hose assembly.

In some aspects, the techniques described herein relate to a system, wherein the die set further includes die circuitry having a die identification, wherein the die identification compares the die identification with a database to verify the die set.

In some aspects, the techniques described herein relate to a method of operating a die verification system, the method including: providing a die identification system including a die identification for a die set; inserting the die set into a die holder of a crimper machine and activating the die identification system; providing a die identification by the die identification system to a crimp machine controller; referencing a crimp database with the die identification by the crimp machine controller; and verifying whether the die set can be used for a crimp process.

In some aspects, the techniques described herein relate to a method of operating a die verification system, the method including: storing a die identification into a memory of circuitry; storing die set additional information into the memory; positioning the circuitry into a die set; inserting the die set into a die holder of a crimp machine; and providing the die identification and the additional information to a crimp machine controller.

In some aspects, the techniques described herein relate to a method of operating a die verification system, the method including: select crimp specifications including hose information and fitting information; entering die change mode by the crimper; inserting die set having die identification into verification die holder; activating the die verification system; receiving the identification from the die set; and verifying the die set based on the received identification.

In some aspects, the techniques described herein relate to a die verification system including: a die holder of a crimp machine, the die holder configured to receive die identification; a user interface; a data interface; a controller having one or more processors configured to: receive the die identification from the die holder; reference a crimp database with the die identification, fitting information and hose information; and verify that the die identification is suitable for a crimp process.

In some aspects, the techniques described herein relate to a system, the die holder configured to receive the die identification upon insertion of a set of dies into the die holder.

In some aspects, the techniques described herein relate to a system, the die holder configured to transmit the die identification to the controller.

In some aspects, the techniques described herein relate to a system, the one or more processors configured to send a verification that the die identification is suitable to the user interface.

In some aspects, the techniques described herein relate to a system, further including a crimper housing that contains the controller, the user interface, and the data interface.

In some aspects, the techniques described herein relate to a system, wherein the user interface is a graphical user interface of a crimper.

In some aspects, the techniques described herein relate to a system, the one or more processors configured to perform a crimp process based on the die identification.

In some aspects, the techniques described herein relate to a system, the die holder further including a contact frame and a contact rail.

In some aspects, the techniques described herein relate to a system, wherein the contact rail provides a power connection and a data connection to a contact of the die identification system.

In some aspects, the techniques described herein relate to a system, the die holder has a round a shape.

In some aspects, the techniques described herein relate to a system, the die holder has a frame that secures a die set into the die holder.

In some aspects, the techniques described herein relate to a system, the frame includes a contact rail that extends around an interior of the contact frame, the contact rail including a conductive material.

In some aspects, the techniques described herein relate to a method of operating a die verification system, the method including: select crimp specifications including hose information and fitting information; entering die change mode by the crimper; inserting die set having die identification into verification die holder; activating the die verification system; receiving the identification from the die set; and verifying the die set based on the received identification.

In some aspects, the techniques described herein relate to a method, further including performing a crimp operation.

In some aspects, the techniques described herein relate to a method, where the die set includes circuitry having the die identification.

Although a few embodiments of the disclosure have been described in detail above, those of ordinary skill in the art will readily appreciate that many modifications are possible without materially departing from the teachings of this disclosure. Accordingly, such modifications are intended to be included within the scope of this disclosure as defined in the claims.

## Claims

1. A die verification system comprising:
a die holder of a crimp machine, the die holder configured to receive die identification;
a user interface;
a data interface;
a controller having one or more processors configured to:
receive the die identification from the die holder;
reference a crimp database with the die identification, fitting information and hose information; and
verify that the die identification is suitable for a crimp process.

2. The system of claim 1, the die holder configured to receive the die identification upon insertion of a set of dies into the die holder.

3. The system of claim 1, the die holder configured to transmit the die identification to the controller.

4. The system of claim 1, the one or more processors configured to send a verification that the die identification is suitable to the user interface.

5. The system of claim 1, further comprising a crimper housing that contains the controller, the user interface, and the data interface.

6. The system of claim 1, wherein the user interface is a graphical user interface of a crimper.

7. The system of claim 1, the one or more processors configured to perform a crimp process based on the die identification.

8. The system of claim 1, the die holder further comprising a contact frame and a contact rail.

9. The system of claim 8, wherein the contact rail provides a power connection and a data connection to a contact of the die identification system.

10. The system of claim 1, the die holder has a round a shape.

11. The system of claim 1, the die holder has a frame that secures a die set into the die holder.

12. The system of claim 1, the frame includes a contact rail that extends around an interior of the contact frame, the contact rail comprising a conductive material.

13. A method of operating a die verification system, the method comprising:
select crimp specifications including hose information and fitting information;
entering die change mode by the crimper;
inserting die set having die identification into verification die holder;
activating the die verification system;
receiving the identification from the die set; and
verifying the die set based on the received identification.

14. The method of claim 10, further comprising performing a crimp operation.

15. The method of claim 13, the die set comprises circuitry having the die identification.
